Europäisches Patentamt

European Patent Office

Office européen des brevets

(19)

(11) Numéro de publication : **0 388 842 B1**

(12) **FASCICULE DE BREVET EUROPEEN**

(45) Date de publication du fascicule du brevet :
09.11.94 Bulletin 94/45

(51) Int. Cl.⁵ : **H04L 7/04**

(21) Numéro de dépôt : **90105120.1**

(22) Date de dépôt : **19.03.90**

(54) **Procédé et dispositif de recherche de synchronisation des trames recues en transmission numérique.**

(30) Priorité : **23.03.89 FR 8903834**

(43) Date de publication de la demande :
**26.09.90 Bulletin 90/39**

(45) Mention de la délivrance du brevet :
**09.11.94 Bulletin 94/45**

(84) Etats contractants désignés :
**DE ES FR GB IT NL SE**

(56) Documents cités :
**EP-A- 0 100 820**
**US-A- 3 466 601**
**PATENT ABSTRACTS OF JAPAN, vol. 8, no. 161 (E-257)[1598], 26 juillet 1984; & JP-A-59 61 328 (FUJITSU K.K.) 07-04-1984**
**PATENT ABSTRACTS OF JAPAN, vol. 10, no. 116 (P-452)[2173], 30 avril 1986; & JP-A-60 246 065 (HITACHI SEISAKUSHO K.K.) 05-12-1985**

(73) Titulaire : **ALCATEL TELSPACE**
**5, rue Noel Pons**
**F-92734 Nanterre Cédex (FR)**

(72) Inventeur : **Kamanou, Pierre-François**
**79, rue Henri Barbusse**
**F-93300 Aubervilliers (FR)**
Inventeur : **Caquot, Christophe**
**50, rue Louis Blanc**
**F-92400 Courbevoie (FR)**

(74) Mandataire : **Weinmiller, Jürgen et al**
**Lennéstrasse 9**
**Postfach 24**
**D-82336 Feldafing (DE)**

## Description

La présente invention se rapporte à un procédé et à un dispositif de recherche de synchronisation des trames reçues en transmission numérique, en particulier par faisceau hertzien.

Le multiplexage de trames hertziennes est une technique largement utilisée dans les faisceaux hertziens numériques qui consiste à insérer périodiquement dans les bits du train principal à transmettre un message contenant des informations supplémentaires d'exploitation ou d'utilisation que l'on désigne par "extra-bits".

On appelle ainsi trame le motif temporel répétitif induit par le multiplexage des extra-bits. Une trame comporte M secteurs de r + q bits où r est le nombre de bits d'information et q est le nombre d'extra-bits.

Parmi les extra-bits, on distingue les bits d'indication de justification (ce procédé utilise le principe de la justification positive), le mot de verrouillage de trame (pour retrouver la synchronisation des trames), les informations binaires d'utilisation pour la transmission d'affluents auxiliaires, les voies de service et les bits de contrôle du code correcteur d'erreur.

Dans les faisceaux hertziens numériques utilisant des modulations de type MAQ2$^m$, le schéma général de codage comporte les fonctions suivantes :
- embrouillage des signaux tramés à l'exception du mot de verrouillage de trame ;
- codage différentiel ;
- codage correcteur d'erreur.

Quel que soit le code correcteur C(n,k) utilisé, de type bloc ou convolutif, on doit pouvoir insérer dans la trame, aux emplacements prévus, les n-k bits de contrôle calculés par le codeur à partir d'une séquence de données résultant du multiplexage des bits d'information et des autres extra-bits divisée en secteurs de n bits.

Traditionnellement, la synchronisation de la réception sur l'émission est assurée par la présence de mots de verrouillage de trame (M.V.T.) à éléments binaires isolés, répartis dans les extra-bits des différents secteurs de la trame, dont la reconnaissance en réception assure un bon fonctionnement.

Plus précisément, on définit un critère de perte de verrouillage de trame, de symbole a, et un critère de reprise de verrouillage de trame, de symbole 1 + d' ; tels que :
- le verrouillage de trame est décrété perdu lorsque le démultiplexeur en réception a trouvé a M.V.T. consécutifs ;
- le verrouillage de trame est décrété retrouvé lorsque 1 + d'mots sans erreurs ont été détectés consécutivement ; après avoir détecté un mot de contenu identique à celui du M.V.T., le récepteur doit retrouver ce mot dans les d' trames suivantes ; d' est le nombre de confirmations de la détection du M.V.T.

Les perturbations qui peuvent affecter le fonctionnement d'un équipement sont les suivantes :
- pertes réelles de verrouillage de trame par décalage de la base de temps ;
- pertes fictives à cause des erreurs de transmission empêchant la détection du M.V.T. ;
- mauvaise reconnaissance des indications de justification à cause des erreurs de transmission créant un décalage d'un temps élémentaire, donc une perte de M.V.T. au niveau du démultiplexeur de rang inférieur.

Le procédé classique de synchronisation consiste en la recherche préalable de la synchronisation secteur, ce qui permet d'obtenir plus facilement la synchronisation trame.

Dans la pratique, il s'agit de comparer le train reçu échantillonné par un signal de synchronisation à la fréquence secteur fourni par une base de temps au M.V.T. émis ou à une de ses permutations circulaires. Cette comparaison se fait de trame en trame. Tant qu'il n'y a pas égalité, un ordre de décalage du signal de synchronisation de la base de temps est donné après le déroulement de d' trames. Au pire, il faudra N décalages successifs (N : nombre de bits par secteur) pour que l'égalité ait lieu, si on suppose que la probabilité de déclarer à tort qu'il n'y a pas égalité, à cause d'erreurs de transmissions, est négligeable. De plus, on suppose négligeable les probabilités d'imitation et à fortiori de fausse synchronisation.

L'égalité se traduit donc par le changement d'état de la sortie du comparateur : la synchronisation secteur est indiquée par l'apparition d'un signal périodique avec la trame dont les impulsions durent un secteur.

On estime ainsi le temps maximum de synchronisation secteur dans les circuits de l'ordre de :

$$\frac{1 + (d' + 1)(N - 1)}{Ft}$$

où Ft est la fréquence de trame.

Pour déclarer la synchronisation de la réception sur l'émission, une fois la synchronisation secteur obtenue, le signal de début de trame fourni par la base de temps réception doit être mis en phase avec le signal issu du comparateur après que ce dernier ait été confirmé d' fois de suite. Ceci est réalisé par décalages successifs de la base de temps, grâce au blocage d'une période d'horloge secteur à chaque trame, jusqu'à la synchronisation qui n'est validée que d' trames plus tard.

Ainsi, le temps maximal de synchronisation trame est de :

EP 0 388 842 B1

$$\frac{M + d'}{Ft}$$

où M est le nombre de secteurs dans une trame.

Au total, le temps maximum de synchronisation est donc de :

$$\frac{1 + (1 + d')(N - 1) + M + d'}{Ft} = \frac{(d' + 1)N + M}{Ft}$$

Avec une valeur classique de 3 pour $d'$, le temps de recherche de synchronisation peut être très long, de d'ordre de 4N/Ft. A titre d'exemple, avec les valeurs courantes :

$$N = 32 \text{ et } M = 18,$$

le temps maximal de synchronisation est de l'ordre 146 trames.

La demande de brevet européen n° 0 100 820 au nom d'ANT décrit un dispositif de synchronisation de trames de données numériques. Chaque trame transmise comporte k bits d'information utile et r bits de protection contre les erreurs obtenus par codage des k bits d'information utile. Le récepteur comporte un démultiplexeur placé en amont d'un codeur identique à celui utilisé à l'émission. Le démultiplexeur sélectionne k bits dans le signal reçu et les applique au codeur qui fournit, lorsqu'une synchronisation de trame est obtenue, r bits codés identiques à ceux présents dans le signal reçu. On considère qu'une synchronisation de trames est obtenue lorsqu'un nombre suffisant d'identités entre les r bits codés et les r bits reçus est observé. Lorsque les r bits issus du codeur sont différents des r bits reçus (suivant les k bits d'information utile), le démultiplexeur est commandé avec un décalage d'un temps bit pour faire glisser la fenêtre de sélection sur le signal reçu.

Ce document ne traite pas de la synchronisation secteur. De plus, ce dispositif suppose un codage spécial au niveau réception pour détecter la synchronisation et les trames reçues ne comportent pas de mot de verrouillage de trame.

L'invention vise à remédier à cet inconvénient. Elle se rapporte à cet effet à un procédé de recherche de synchronisation des trames reçues dans une installation de transmission numérique, en particulier par faisceau hertzien, cette installation comportant un dispositif de codage/décodage correcteur d'erreur utilisant soit un code en bloc non cyclique, soit un code convolutif, ce dispositif de codage/décodage utilisant un ou plusieurs décodeurs correcteurs d'erreur fonctionnant en parallèle (un décodeur correcteur d'erreur par train binaire reçu). Ce procédé, selon lequel, et de manière connue en soi, on recherche tout d'abord la synchronisation-secteur puis on en déduit, à l'aide du mot de verrouillage de trame (M.V.T.), la synchronisation-trame, consiste à trouver cette synchronisation-secteur en inhibant tout d'abord la correction du ou des décodeurs correcteurs d'erreur, puis en laissant entrer dans ce ou ces décodeurs un nombre L de bits égal au nombre total n de bits de données par mot dans le cas d'un code en blocs ou à la longueur de contrainte du code dans le cas d'un code convolutif, en examinant alors l'état du ou des syndromes délivrés par ce ou ces décodeurs, et, dans le cas où ils ne sont pas tous nuls, en décalant alors d'une impulsion le signal de synchronisation-secteur, en préparant alors, si nécessaire, ce ou ces décodeurs pour la réception de L bits suivants, et ainsi de suite jusqu'à ce que ce ou ces syndromes aient été trouvés tous nuls un nombre de fois consécutives d prédéterminé, la synchronisation-secteur n'étant plus décalée pendant ces d répétitions si elles sont positives, en conséquence de quoi la synchronisation-secteur est déclarée trouvée, ensuite de quoi le ou les désembrouilleurs de l'installation de réception sont inhibés, s'ils ne l'avaient pas déjà été en même temps que la correction d'erreur, et la recherche de synchronisation de trame est effectuée, de manière connue en soi, en extrayant, à l'aide du démultiplexeur d'extra-bits équipant cette installation de réception, les extra-bits relatifs au mot de verrouillage de trame, en comparant ces extra-bits au mot de verrouillage de trame, et en initialisant en conséquence, lorsque la coïncidence a été trouvée, le compteur-trame de la base de temps, la synchronisation trame étant déclarée trouvée après confirmation de ce processus sur plusieurs trames consécutives.

De toute façon, l'invention sera bien comprise, et ses avantages et autres caractéristiques ressortiront, lors de la description suivante d'un exemple non limitatif de réalisation appliqué à une installation utilisant un codage/décodage correcteur d'erreur employant le code de WYNER-ASH, en référence au dessin schématique que annexé dans lequel :

- Figure 1 est l'algorithme général de recherche de la synchronisation-secteur ;
- Figure 2 est un schéma d'ensemble de la partie de l'installation de réception qui est apte à effectuer la recherche de synchronisation de trame ;
- Figure 3 est un schéma du décodeur correcteur d'erreur de WYNER-ASH utilisé dans l'installation de la figure 2;
- Figure 4 est l'algorithme de recherche de la synchronisation-secteur utilisé dans cet exemple particulier ; et
- Figure 5 est le diagramme des états de l'automate de recherche de synchronisation-secteur utilisé dans l'installation de la figure 2.

D'une façon très générale, l'invention consiste à utiliser le ou les bits de syndrome délivrés par le décodage

3

correcteur d'erreur pour retrouver, à la réception, la synchronisation-secteur, et ensuite la synchronisation-trame en s'aidant classiquement du mot de verrouillage de trame (M.V.T.). L'innovation se situe donc essentiellement dans la recherche de synchronisation-secteur. L'invention s'applique aux installations utilisant, pour la correction d'erreur, soit un code en bloc, soit un code convolutif, mais elle ne peut être pratiquement mise en oeuvre que s'il s'agit d'un code non-cyclique. Par ailleurs, comme on le comprendra ci-après, elle n'est applicable qu'aux transmissions à taux d'erreur binaire faible, pas sensiblement supérieur à $10^{-4}$ pour fixer les idées, ce qui est pratiquement le cas dans les transmissions numériques civiles par faisceau hertzien où le taux d'erreur binaire est généralement de l'ordre de $10^{-6}$.

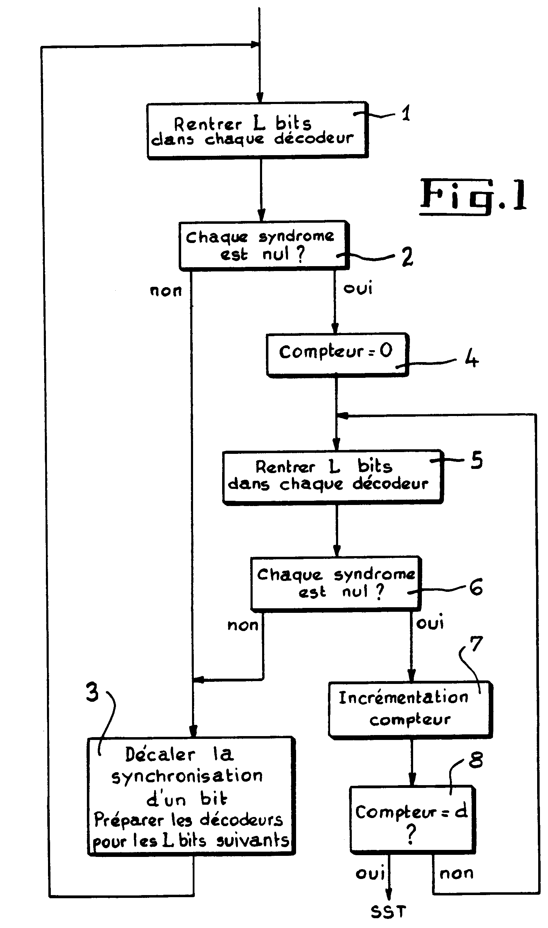

L'algorithme général de recherche de la synchronisation-secteur, qui est réalisé après l'inhibition préalable de la correction d'erreur (pour ne pas effacer en cas de correction les bits de syndrome successifs, qui sont nécessaires à cette recherche de synchronisation), est représenté sur la figure 1, et peut-être détaillé comme suit :

La phase 1 consiste à rentrer L bits successifs du ou des trains binaires reçus dans chaque décodeur. Dans le cas d'un code en blocs, L est le nombre total n de bits par mot du code, tandis que dans le cas d'un code convolutif, L est égal à la longueur de contrainte du code (égale au nombre n de bits par secteur, multiplié par l'ordre m de la mémoire du code).

On passe alors à la phase 2 qui consiste à regarder si tous les bits de syndrome délivrés par ces décodeurs sont nuls. Si en effet tous ces bits de syndrome sont nuls, et si (ce qui est très probable avec un taux d'erreur binaire faible) il n'y a pas d'erreur dans ces L bits reçus, il existe un maximum de chances pour que la synchronisation délivrée par la base de temps soit la synchronisation-secteur recherchée.

Considérons d'abord le cas, indiqué "non", où ces bits de syndrome ne sont pas tous nuls. On passe alors à la phase 3, en espérant alors que ces syndromes non tous nuls indiquent que la synchronisation-secteur est mauvaise.

En phase 3, on décale la synchronisation délivrée par la base de temps d'un bit (c'est à dire d'une impulsion d'horloge), on prépare (si nécessaire) les décodeurs pour la réception des L bits suivants, et l'on repasse à l'état 1, en espérant donc que la nouvelle synchronisation (obtenue par ce décalage d'un bit) est la bonne. On continue ainsi jusqu'à ce qu'en phase 2, tous les syndromes aient été trouvés nuls : cas indiqué "oui".

Il n'est alors pas raisonnable de décréter d'emblée que la synchronisation-secteur est trouvée, car il peut s'agir là d'un hasard. Il faut confirmer cette information un nombre d de fois successives suffisant qui est déterminé cas par cas à l'aide d'un calcul de probabilités, mais qui est le plus souvent compris entre 2 et 5 :

$$2 \leqq d \leqq 5$$

On passe alors à la phase 4, qui consiste à initialiser à zéro un compteur de nombre de confirmations d.

On passe ensuite à la phase 5, puis à la phase 6, qui sont respectivement identiques aux phases 1 et 2 précitées.

Si la réponse en phase 6 est "non", c'est qu'il s'agissait bien d'un hasard, et que la synchronisation-secteur n'avait pas été trouvée : on repasse alors à la phase 3 afin de poursuivre la recherche par décalages successifs de la synchronisation délivrée par la base de temps.

Si la réponse à la question posée en phase 6 est "oui", on incrémente, en phase 7, le compteur précité d'une unité, et on compare, en phase 8, son contenu avec le nombre d. S'ils ne sont pas égaux, réponse "non", c'est qu'il faut encore confirmer une ou plusieurs fois, et on repasse alors en phase 5. S'ils sont égaux, réponse "oui", c'est qu'on a confirmé un nombre de fois égal à d, et qu'en conséquence la synchronisation-secteur est trouvée : signal SST.

Si le taux d'erreur binaire était totalement nul, le temps maximal de recherche de la synchronisation-secteur, exprimé en bits, serait égal à :

$$(n \ + \ d) \, L$$

où n est de nombre de bits par mot du code, puisqu'il faudrait au maximum décaler n fois la synchronisation délivrée par la base de temps, puis confirmer d fois.

Il en est pratiquement de même tant que le taux d'erreur binaire reste faible, en pratique non supérieur à $10^{-4}$. En revanche, si celui-ci devient plus important, il se produit un nombre préjudiciable de "ratés de synchronisation-secteur". Tel est le cas lorsque, alors qu'en réalité la synchronisation-secteur est identique à la synchronisation de la base de temps, donc bonne, la réponse à la phase 2 est "non" parce que le message reçu comporte une erreur : la synchronisation est alors décalée à tort en phase 3, et il faut attendre n nouvelles recherches pour retrouver le même cas, correspondant à l'identité des deux synchronisations précitées. Dans de telles conditions, si ceci se reproduit trop souvent (ce qui, comme le montre le calcul, est généralement le cas si le taux d'erreur binaire est supérieur à $10^{-4}$), le temps de recherche croît exagérément et le procédé conforme à l'invention ne présente plus d'intérêt, n'étant pas compétitif.

Le décalage des signaux de synchronisation peut perturber le fonctionnement du décodeur : il faut s'affranchir de ce problème.

Dans le cas des codes en bloc, le syndrome d'un bloc ne dépend que du bloc en question et donc le décalage de synchronisation n'est pas gênant pour le calcul du syndrome du bloc qui suit ce décalage.

En revanche, dans le cas des codes convolutifs, le syndrome d'une séquence de L bits (c'est à dire d'une longueur de contrainte) dépend de la séquence précédente. Ainsi, le calcul du syndrome de la séquence de L bits suivant le décalage de synchronisation dépend de la séquence précédant ce décalage ; on considérera deux cas selon la structure du décodeur :

- soit le décodeur peut calculer les bits de syndrome correctement en dépit d'un décalage de la synchronisation (ce qui suppose qu'il calcule les bits de contrôle de façon continue) ;
- soit ce n'est pas possible et il faut attendre le déroulement d'un bloc de L bits pour un nouveau calcul de syndrome (ce qui double le temps de synchronisation).

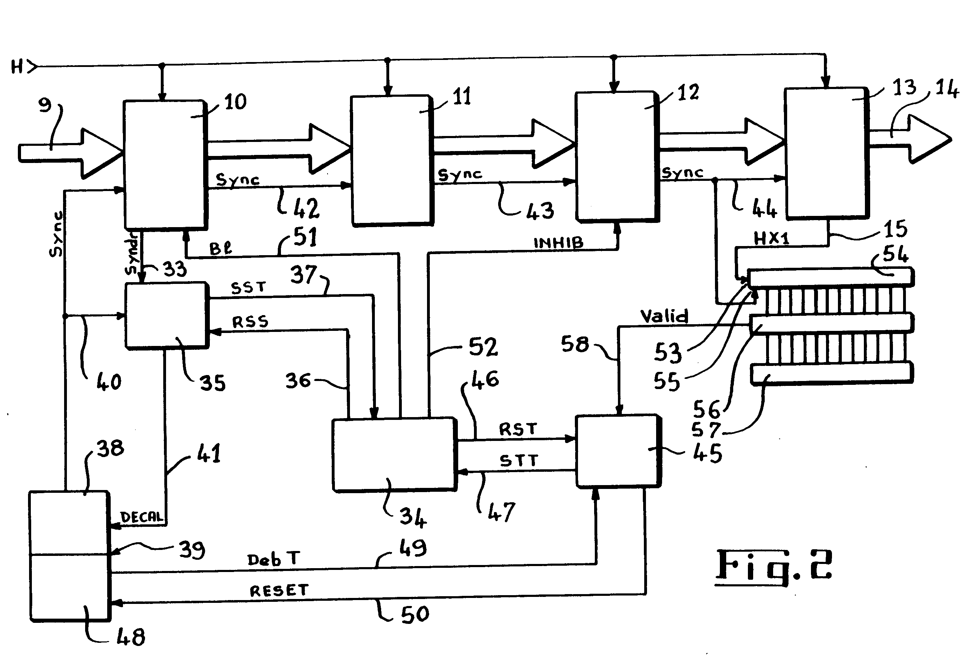

La figure 2 donne un schéma pratique de réalisation dans le cas d'une installation de transmission numérique par faisceau hertzien qui utilise, pour chaque train binaire, un codeur/décodeur correcteur d'erreur de WYNER-ASH, par exemple essentiellement tel que décrit en détails dans la demande de brevet français antérieure N°8902407, déposée par la demanderesse le 24 février 1989, sous le titre : "Codeur/décodeur correcteur d'erreur pour installation de transmission numérique".

Le code de WYNER-ASH est par exemple décrit dans l'ouvrage de l'auteur russe ALEXANDRU SPATARU "Fondements de la théorie de la transmission de l'information", publié en France par les "Presses Polytechniques Romandes", 1987 p. 132 à 136.

Il s'agit d'un code convolutif systématique qui permet de corriger une erreur et une seule dans toute la longueur de contrainte, quelle que soit la position qu'elle occupe dans un bloc.

Ses trois paramètres : k (nombre de bits d'information à l'entrée du codeur), n (nombre de bits en sortie de ce codeur), et m (ordre de la mémoire de retard que comprend ce codeur) sont définis par les relations suivantes :

$$k = 2^p - 1$$
$$n = k + 1$$
$$m = p + 1$$

où p est un nombre entier.

Dans le cas des transmissions numériques, le taux de redondance du code ne doit pas sensiblement dépasser 3 %, pour réduire les perturbations entre canaux, ce qui conditionne le choix de ce nombre p. Le calcul montre dans ces conditions qu'il faut choisir un entier p supérieur ou égal à 5. En particulier, si l'on choisit p égal à 5, on obtient un code pour lequel k = 31 et n = 32 , ce qui donne un taux de redondance, acceptable, de 3,2 %.

Ce code est tel que le bit de contrôle Yi d'un bloc de n bits qui sort du codeur à l'instant i est calculé en fonction des k autres bits du même bloc à cet instant i (Xi,1 ; Xi,2 ; Xi,3 ;...; Xik), en fonction de ces mêmes k autres bits à l'instant i - 1 (Xi - 1,1 ; Xi - 1,2 ;...; Xi - 1,k), etc..., et finalement en fonction de ces mêmes k autres bits à l'instant i - m (Xi - m,1 ;...; Xi - m,k), en réalisant l'addition modulo 2 de tous les k autres bits présents aux instants i, i - 1,..., i - m, et affectés respectivement chacun d'un coefficient A, égal à zéro ou à un, qui est défini par la matrice de génération du code :

```
R1 = A1,1      A1,2  ..............  A1,k

R2 = A2,1      A2,2  ..............  A2,k

.....................................................

Rm = Am,1      Am,2  ..............  Am,k
```

avec la remarque que les coefficients de la première ligne R1 de cette matrice (A1,1 à A1,k) sont tous égaux à 1.

Dans l'application présente, il s'agit d'une installation de transmission numérique par faisceau hertzien qui est équipée, pour chaque train binaire, d'un codeur de correction d'erreur (non représenté) utilisant un code correcteur d'erreur de Wyner-Ash dont le nombre entier p ci-dessus défini est égal à 5 (soit : m égal à 6). Ce codeur utilise m registres à décalage en série, dont au moins les p premiers comportent chacun n bascules, les sorties des k premières bascules du premier de ces registres à décalage étant reliées à un premier circuit OU EXCLUSIF, les sorties des k premières bascules du deuxième registre à décalage étant reliées à un deuxième circuit OU EXCLUSIF si elles correspondent à un coefficient (A2,1 ; A2,2 ;...; ou A2,k) de la deuxième ligne R2 de la matrice précitée de génération du code égal à 1, et n'étant pas connectées lorsqu'elles correspondent à un coefficient égal à 0, et ainsi de suite jusqu'au m-ième registre à décalage, lui-même associé de la même façon à un m-ième circuit OU EXCLUSIF, les m sorties de ces m circuits OU EXCLUSIF étant toutes reliées

EP 0 388 842 B1

à un autre circuit OU EXCLUSIF dont la sortie est appliquée à l'une des deux entrées d'un multiplexeur d'entrée du codeur, ce multiplexeur recevant sur son autre entrée les séquences successives constituées chacune par k bits d'information, suivis d'un espace apte à recevoir un bit de contrôle, l'entrée de commande de ce multiplexeur étant un signal périodique (Sync) qui est apte à relier sa sortie au fil d'amenée des k bits d'information pendant le passage de ces k bits et à la sortie de cet autre circuit OU EXCLUSIF pendant l'espace réservé à l'insertion du bit de contrôle, cette sortie du multiplexeur attaquant d'une part le premier registre à décalage, et d'autre part une bascule de repointage dont la sortie forme la sortie de ce codeur-série de WYNER-ASH.

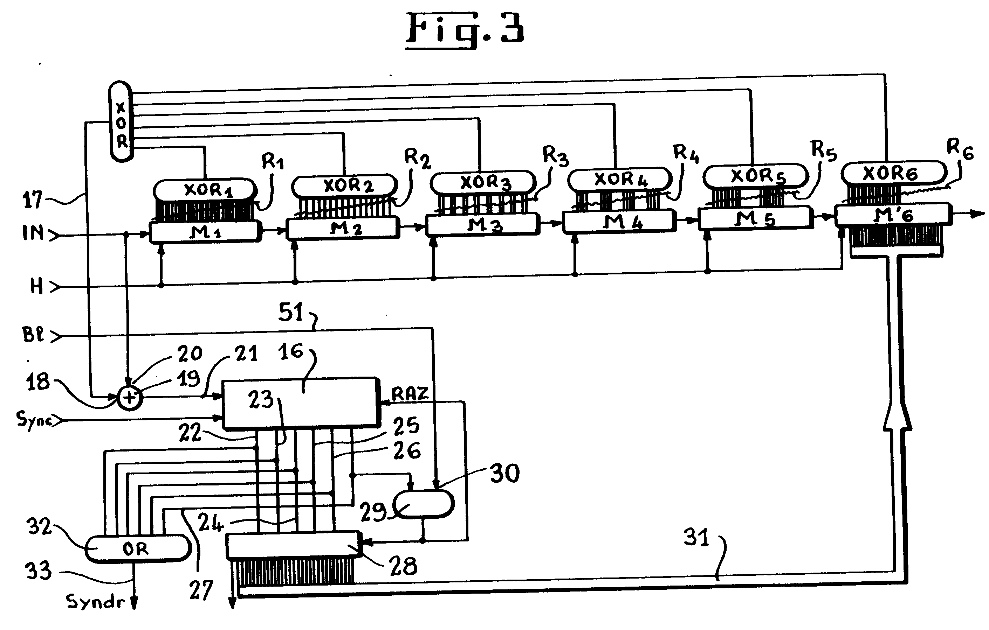

Du côté réception (figure 2), il est prévu, pour chaque train binaire reçu en 9 (deux trains binaires reçus dans le cas d'une modulation MDP4), un décodeur correcteur série 10 de WYNER-ASH, calqué sur le codeur d'émission et qui sera décrit plus en détails en référence à la figure 3, puis un décodeur différentiel 11 commun à tous les trains, puis un désembrouilleur 12 par train, puis un démultiplexeur d'extra-bits 13, dont sort en 14 le train principal et, entre autres sorties d'extra-bits, les extra-bits de position de M.V.T. en 15. Pour simplifier, il n'est figuré sur le dessin qu'un seul décodeur 10 et qu'un seul désembrouilleur 12.

Le décodeur-série de WYNER-ASH 10 est légèrement différent de celui décrit dans la demande de brevet français N°8902407 précitée. En effet, la structure du décodeur-série de Wyner-Ash ne permet pas de calculer les bits de syndrome de la séquence de L bits qui suit un décalage de synchronisation, puisque les bits de syndrome qui ont été calculés avant ce décalage ont altéré le message.

Plutôt que d'attendre le déroulement d'un bloc de L bits pour un nouveau calcul de syndrome, ce qui doublerait le temps de synchronisation, il vaut mieux modifier légèrement le décodeur de Wyner-Ash en lui donnant la structure représentée en figure 3, par laquelle les bits de syndrome, au lieu d'être écrits dans le train reçu à la place des bits de contrôle, sont stockés dans un registre à décalage 16 à m bascules (m = 6 dans le cas considéré où il s'agit d'un code de WYNER-ASH 32,31,6). Ce registre 16 fonctionne au rythme du signal périodique Sync précité, et non pas, comme c'est le cas pour la série de registres à décalage M1 à M'6 du décodeur proprement dit, au rythme de l'horloge H du train reçu, qui entre en IN dans ce décodeur. Cette modification présente l'avantage de ne pas altérer le signal rentrant, et donc de permettre un calcul correct de syndrome après un décalage de synchronisation en phase 3 de l'algorithme de la figure 1.

En considérant plus en détails cette figure 3, il s'agit d'un décodeur correcteur d'erreur série de WYNER-ASH pour lequel le nombre entier p précité est égal à 5.

Les trois paramètres de ce code sont donc :

$$k = 2^p - 1 = 31$$
$$n = k + 1 = 3$$
$$m = p + 1 = 6$$

Sa matrice de génération est constituée par les six lignes R1 à R6 suivantes :

R1 : 1111111111111111111111111111111

soit 31 fois le coefficient "1"

R2 : 1010101010101010101010101010101

soit alternativement un "1" et un "0"

R3 : 1100110011001100110011001100110

soit des suites de deux "1" séparées par deux "0"

R4 : 1111000011110000111100001111000

soit des suites de quatre "1" séparées par quatre "0"

R5 : 1111111100000000111111110000000

soit des suites de huit "1" séparées par huit "0"

R6 : 1111111111111111000000000000000

soit une suite de seize "1" suivie par quinze "0"

Le décodeur proprement dit comporte six registres à décalage en série M1 à M'6. Les registres M1 à M5 sont des registres à 32 bascules. Le registre M'6 comporte une bascule supplémentaire (bascule de repointage de sortie), et est donc un registre à 33 bascules.

Les sorties des 31 premières bascules du premier registre M1 sont affectées des coefficients respectifs définis par la première ligne R1 de la matrice de génération, et sont par suite toutes connectées à un premier circuit "OU EXCLUSIF" XOR1.

De même, les 31 premières sorties du deuxième registre M2 sont reliées à un deuxième circuit "OU EXCLUSIF" XOR2 lorsqu'elles correspondent à un coefficient de la ligne R2 égal à 1, tandis qu'elles ne sont pas connectées lorsqu'elles correspondent à un coefficient de cette ligne R2 égal à 0, de sorte qu'une sortie sur deux est finalement connectée à XOR2, et ainsi de suite jusqu'au dernier registre M'6 qui est connecté à XOR6 conformément à la sixième ligne R6 de la matrice.

Les six sorties respectives des six circuits "OU EXCLUSIF" XOR1 à XOR6 sont toutes reliées à un autre circuit "OU EXCLUSIF" XOR dont la sortie 17 est appliquée à l'entrée 18 d'un additionneur logique 19 à deux

6

entrées qui reçoit sur son autre entrée 20 le train binaire incident IN. La sortie 21 du sommateur 19 attaque le registre à décalage 16 précité.

Les cinq premières sorties 22 à 26 du registre 16 sont connectées à un convertisseur binaire-décimal 28, qui est validé par sa dernière sortie 27, à travers une porte 29, qui est fermée lorsqu'elle reçoit sur son autre entrée le signal d'inhibition de correction B1. Ce signal de validation remet à zéro le registre 16 (entrée RAZ).

Les syndromes présents sur les fils 22 à 26 donnent la position de l'erreur, et cette position, apparaissant sur un des 31 derniers fils de sortie du convertisseur 28, est transmise par le bus 31, au dernier registre M'6 pour y corriger, à l'aide de circuits OU EXCLUSIF, l'erreur là où elle se trouve.

En outre, les six fils de sortie 22 à 27 du registre 16 sont connectés à un circuit OU 32, dont la sortie 33 indique si tous les bits de syndrome sont ou ne sont pas tous nuls (voir les phases 2 et 6 de l'algorithme de la figure 1), en émettant le signal "Syndr" si ceux-ci sont tous non nuls.

En revenant à la figure 2, les deux recherches de synchronisation, secteur puis trame, sont commandées par un séquenceur 34 qui pilote lui-même deux automates à états, dont :

- Un automate 35 de recherche de synchronisation-secteur. Cet automate reçoit du séquenceur 34 un signal RSS de demande de recherche de synchronisation-secteur, par la liaison 36. Il fournit à ce séquenceur un signal SST (synchronisation-secteur trouvée) par la liaison 37. Il reçoit par l'entrée 40, et en provenance du compteur-secteur 38 de la base de temps 39, le signal périodique Sync qui indique la position du bit de contrôle dans chaque mot reçu. Il donne, par la liaison 41, des ordres DECAL de blocage du compteur-secteur pour décaler le signal Sync d'un coup d'horloge.

  A noter que le signal Sync de position des bits de contrôle permet le repérage des extra-bits : dans ce but, il est transmis en cascade des décodeurs-correcteurs 10 vers le décodeur différentiel 11 par le fil 42, de 11 vers les désembrouilleurs 12 par le fil 43, et de ces derniers vers le démultiplexeur d'extra-bits 13 par le fil 44.

- Un automate 45 de recherche de synchronisation-trame, qui reçoit du séquenceur 34, et par la liaison 46, un signal RST de demande de recherche de synchronisation-trame, et qui lui fournit, par la liaison 47, un signal STT (synchronisation de trame trouvée). Il reçoit, du compteur-trame 48 de la base de temps (qui est lui-même commandé par le compteur-secteur 38), un signal DebT de début de trame par le fil 49, et il lui fournit, par le fil 50, un signal de remise à zéro RESET.

Le séquenceur 34 fournit en outre, par le fil 51, un signal B1 de blocage de correction du ou des décodeurs-correcteurs 10, et par le fil 52 un signal INHIB d'inhibition des ou des désembrouilleurs 12.

Les extra-bits HX1 de M.V.T. qui sortent en 15 du démultiplexeur 13, et qui contiennent le mot de verrouillage de trame M.V.T. de 12 bits, sont appliqués en 53 à un registre à décalage 54 de 12 bits (les 12 derniers extra-bits de chaque trame comportant le M.V.T.), qui est synchronisé en 55 par le signal Sync en provenance de 44.

Les douze bascules du registre 54 sont comparées, dans le circuit de comparaison 56, avec le M.V.T. qui est stocké en permanence dans un registre 57. En cas de coïncidence, le comparateur 56 émet, par le fil 58, un signal Valid vers l'automate 45.

Le fonctionnement du dispositif de la figure 2 est le suivant :

A l'initialisation, le séquenceur 34 émet sur les fils 51 et 52, respectivement un signal BI d'inhibition de la correction du décodeur de WYNER-ASH 10 et un signal INHIB d'inhibition du désembrouillage, et il demande par un signal RSS une recherche de synchronisation-secteur à l'automate 35.

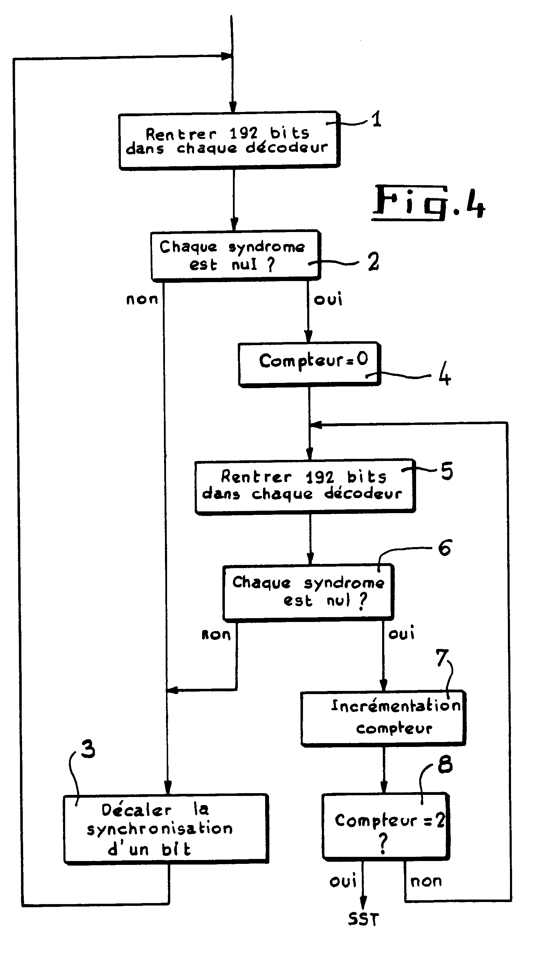

Cet automate 35 fonctionne selon l'algorithme de la figure 4, qui est la transcription, dans cet exemple précis, de celui de la figure 1, avec L égal à six fois 32 bits, soit 192 bits, et d choisi égal à 2. Les phases 1 à 8 de cet algorithme correspondent donc aux phases 1 à 8 de l'algorithme de la figure 1. En phase 3, il n'est pas besoin de préparer les décodeurs pour les L bits suivants, en raison de l'utilisation du registre à syndromes 16 de la figure 3.

L'automate 35 déclare donc la synchronisation-secteur trouvée (signal SST) lorsque, par décalages successifs de la base de temps-secteur 38, il a trouvé tous les syndromes nuls, et a confirmé ce fait encore deux autres fois consécutives à la première.

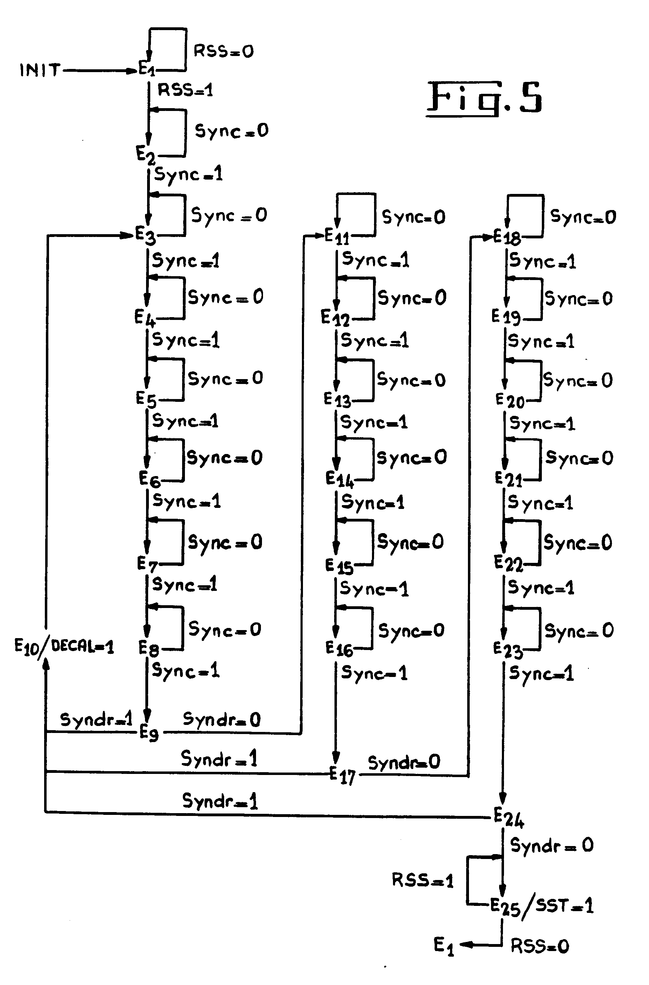

Son diagramme d'états, qui correspond à l'algorithme de la figure 4, est un diagramme à 25 états E1 à E25 qui est, à titre indicatif, représenté sur la figure 5 :

A l'initialisation (INIT), l'automate passe à l'état E1, et y reste tant que le signal RSS est à zéro.

Le passage de RSS à 1 fait passer l'automate à l'état E2 ; il y reste tant que le signal Sync est à zéro.

Un premier signal Sync à 1 le fait passer à l'état E3, et ainsi de suite jusqu'à l'état E8, pour lequel les 192 bits sont rentrés dans le décodeur.

En E9, si l'état du signal Syndr est à 1, il faut décaler la base de temps d'un bit (phase 3 de la figure 4), ce que réalise l'état E10 (DECAL = 1), puis on repasse à l'état E3 pour entrer de nouveaux bits. Si au contraire, Syndr est à zéro, il faut confirmer encore deux fois de suite, selon les états E11 à E17, puis E18 à E24.

Si en E24, le signal Syndr est encore trouvé nul, c'est que la synchronisation-secteur est trouvée. L'automate passe alors en E24 (SST = 1), et y reste tant que le signal RSS du séquenceur 34 reste à 1. Lorsque ce dernier signal passe à zéro, le séquenceur a enregistré la synchronisation-secteur, et l'automate peut repasser à l'état E1, prêt a une nouvelle recherche ultérieure.

En revenant à la figure 2, le séquenceur 34 demande alors, après avoir levé l'inhibition des décodeurs-correcteurs d'erreur par l'accès BI, par l'envoi d'un signal RST sur le fil 46, une recherche de synchronisation de trame à l'automate 45.

Dans un premier temps, l'automate 45 autorise, par le signal RESET sur le fil 50, la remise à zéro du compteur-trame 48 lorsqu'il a reçu, par l'entrée 58, un signal "Valid" en provenance du comparateur 56, signal qui est émis lorsque ce comparateur détecte l'identité entre les 12 derniers extra-bits de HX1 extraits et le M.V.T.

Un signal DebT de début de trame est alors émis sur le fil 49. Après confirmation sur plusieurs trames consécutives de la simultanéité du signal DebT de début de trame donné par la base de temps 39 et du signal d'égalité Valid en sortie du comparateur 56, la sortie SST (synchronisation-trame trouvée) est activée, achevant le processus de synchronisation.

L'inhibition du désembrouilleur 12 est alors levée par le séquenceur 34, de sorte que l'installation de réception peut maintenant fonctionner.

Avec un taux d'erreur binaire inférieur à $10^{-4}$, le temps maximum de recherche de synchronisation-secteur est, pour l'exemple de réalisation décrit ci-dessus, de l'ordre de 34 blocs de 192 bits, soit 11 trames.

Comme il faut au pire attendre trois trames avant d'obtenir la synchronisation de trame, le temps maximum de resynchronisation compté en trames est de l'ordre de 14, ce qui représente une amélioration considérable par rapport aux 146 correspondant à la procédure classique.

## Revendications

1. Procédé de recherche de synchronisation des trames reçues dans une installation de transmission numérique en particulier par faisceau hertzien, cette installation utilisant un codage/décodage correcteur d'erreur à code non cyclique, procédé selon lequel la synchronisation-secteur est recherchée tout d'abord et la synchronisation-trame est recherchée ensuite à l'aide du mot de verrouillage de trame (M.V.T.), caractérisé en ce qu'il consiste à trouver cette synchronisation-secteur en inhibant tout d'abord la correction du ou des décodeurs correcteurs d'erreur (10), puis en laissant entrer dans ce ou ces décodeurs (10) un nombre (L) de bits égal au nombre total (n) de bits par mot dans le cas d'un code en bloc ou à la longueur de contrainte (n.m) du code dans le cas d'un code convolutif, en examinant alors l'état (Syndr) du ou des syndromes délivrés par ce ou ces décodeurs (10), et, dans le cas où ils ne sont pas tous nuls, en décalant alors d'une impulsion le signal (Sync) de synchronisation-secteur, en préparant alors, si nécessaire, ce ou ces décodeurs (10) pour la réception de L bits suivants, et ainsi de suite jusqu'à ce que ce ou ces syndromes aient été trouvés tous nuls un nombre de fois consécutives (d) prédéterminé, la synchronisation-secteur (Sync) n'étant plus décalée pendant ces (d) répétitions si elles sont positives, ensuite de quoi le ou les désembrouilleurs (12) de l'installation de réception sont inhibés (s'ils ne l'avaient pas déjà été en même temps que le correcteur d'erreur) et la recherche de synchronisation de trame est effectuée en extrayant, à l'aide du démultiplexeur d'extra-bits (13) équipant cette installation de réception, les extra-bits (HX1) du mot de verrouillage de trame (M.V.T.), en comparant ceux-ci à ce mot de verrouillage de trame, et en initialisant en conséquence, lorsque la coïncidence a été trouvée, le compteur-trame (48) de la base de temps (39), la synchronisation-trame étant déclarée trouvée après confirmation sur plusieurs trames consécutives.

2. Procédé selon la revendication 1, caractérisé en ce qu'il est effectué sur une transmission numérique dont le taux d'erreur binaire n'est pas sensiblement supérieur à $1.10^{-4}$.

3. Procédé selon la revendication 2, caractérisé en ce que le nombre (d) de fois consécutives de confirmations du fait que lesdits syndromes sont trouvés nuls est compris entre 2 et 5, soit : $2 \leqq d \leqq 5$.

4. Dispositif de recherche de synchronisation de trames reçues dans une installation de transmission numérique utilisant un codage/décodage correcteur d'erreur à code non cyclique, ledit dispositif comprenant en outre un automate de recherche de synchronisation-trame (45) piloté par un séquenceur (34) ainsi qu'une base de temps (39), caractérisé en ce qu'il comporte successivement et pour chaque train binaire reçu, un dispositif de codage/décodage correcteur d'erreur série (10) utilisant le code de WYNER-ASH, un décodeur différentiel (11), un désembrouilleur (12), et un démultiplexeur d'extra-bits (13) fournissant entre autres les extra-bits de position d'un mot de verrouillage de trame (M.V.T.) à un registre à décalage (54), ledit dispositif comportant en plus dudit automate de recherche de synchronisation-secteur (35) un automate de recherche de synchronisation-trame (45) pilotés par ledit séquenceur (34), ledit registre à décalage (54) coopérant avec un circuit de comparaison (56) pour comparer son contenu avec celui d'un registre (57) contenant ledit mot de verrouillage de trame (M.V.T.), ledit automate (35) de recherche de synchronisation-secteur fournissant un signal de détection de synchronisation-secteur lorsque, par décalages successifs de ladite base de temps (39), les syndromes issus dudit dispositif de codage/décodage correcteur d'erreur (10) sont tous nuls.

## Patentansprüche

1.  Verfahren zum Suchen der Synchronisation von in einer digitalen Übertragungseinrichtung empfangenen Rahmen, insbesondere über Richtfunkstrecken, wobei diese Einrichtung eine Fehlerkorrigier-Kodierung-Dekodierung mit nichtzyklischem Kode verwendet und wobei zuerst die Sektorsynchronisation und dann die Rahmensynchronisation mit Hilfe des Rahmenverriegelungswortes (RVM) gesucht wird, dadurch gekennzeichnet, daß das Verfahren darin besteht, die Sektorsynchronisation dadurch zu finden, daß zunächst die Korrektur des oder der Fehlerkorrigier-Dekodierer (10) gesperrt wird, anschließend eine Anzahl (L) von Bits entsprechend der Gesamtzahl (n) der Bits je Wort im Falle eines Blockkodes oder entsprechend der Beschränkungslänge (n · m) des Kodes im Falle eines Konvolutionskodes eingegeben wird, indem dann der Zustand (Syndr) des oder der von dem oder den Dekodierer (10) gelieferten Syndrome geprüft wird und indem das Signal (Sync) des Synchronisationssektors dann um einen Impuls verschoben wird, wenn sie nicht alle 0 sind, und indem dann nötigenfalls der oder die Dekodierer (10) für den Empfang der L folgenden Bits vorbereitet werden, und so weiter, bis das Syndrome oder alle Syndrome eine vorbestimmte Anzahl (d) mal nacheinander als null gefunden wurden, wobei die Sektorsynchronisation (sync) während dieser (d) Wiederholungen nicht mehr verschoben wird, wenn sie positiv sind, woraufhin der oder die Entschlüssler (12) der Empfangseinrichtung gesperrt werden (wenn sie dies nicht schon zur gleichen Zeit wie der Fehlerkorrigierer waren) und die Suche nach der Rahmensynchronisation durch Entnehmen der Extrabits (HX1) bezüglich des in der Empfangseinrichtung enthaltenen Rahmenverriegelungswortes (RVM) mit Hilfe des Extrabitdemultiplexers (13) erfolgt, indem diese Extrabits mit dem Rahmenverriegelungswort verglichen werden und indem daraufhin der Rahmenzähler (48) der Zeitbasis (39) initialisiert wird, wenn die Koinzidenz gefunden worden ist, wobei die Rahmensynchronisation nach Bestätigung anhand von mehreren aufeinanderfolgenden Rahmen als gefunden erklärt wird.

2.  Verfahren nach Anspruch 1, dadurch gekennzeichnet, daß es bei einer digitalen Übertragung durchgeführt wird, deren Bitfehlerrate nicht wesentlich größer als $1 \cdot 10^{-4}$ ist.

3.  Verfahren nach Anspruch 2, dadurch gekennzeichnet, daß die Anzahl (d) der aufeinanderfolgenden Bestätigungen der Tatsache, daß die Syndrome als null gefunden werden, zwischen 2 und 5 liegt, d.h.,: $2 \leqq d \leqq 5$.

4.  Vorrichtung zum Suchen der Synchronisation von Rahmen, die in einer digitalen Übertragungseinrichtung empfangen werden, die eine Kodierung-Dekodierung mit Fehlerkorrektur für nichtzyklischen Kode verwendet, wobei die Vorrichtung einen Rahmensynchronisationssuchautomaten (45), der von einer Ablaufsteuerung (34) gesteuert wird, sowie eine Zeitbasis (39) aufweist, dadurch gekennzeichnet, daß die Vorrichtung nacheinander und für jede empfangene Binärfolge eine serielle Kodier-Dekodierund Fehlerkorrigiervorrichtung (10), die den WYNER-ASH-Kode benutzt einen Differentialdekodierer (11), einen Entschlüssler (12) und einen Extrabitdemultiplexer (13) aufweist, der unter anderem die Positionsextrabits eines Rahmenverriegelungswortes (RVM) an ein Schieberegister (54) liefert, wobei die Vorrichtung außer dem Sektor-Synchronisationssuchautomaten (35) einen Rahmensynchronisationssuchautomaten (45) aufweist, der von der Ablaufsteuerung (34) gesteuert wird, wobei das Schieberegister (54) mit einer Vergleichsschaltung (56) zusammenwirkt, um seinen Inhalt mit dem eines Registers (57) zu vergleichen, das das Rahmenverriegelungswort (RVM) enthält, wobei der Sektorsynchronisationssuchautomat (35) ein Sektorsynchronisationserfassungssignal liefert, wenn bei aufeinanderfolgenden Verschiebungen der Zeitbasis (39) die von der Kodier-Dekodierund Fehlerkorrigiereinrichtung (10) ausgegebenen Syndrome sämtlich null sind.

## Claims

1. Method of synchronising frames received in a digital transmission installation, in particular a microwave digital transmission installation, using non-cyclic code error corrector coding/decoding, in which method sector synchronisation is achieved first followed by frame synchronisation using the frame alignment word (F.A.W.), characterised in that it consists in achieving sector synchronisation by first disabling correction by the error corrector decoder(s) (10) and then allowing to enter said decoder(s) (10) a number (L) of bits equal to the total number ($\underline{n}$) of bits per word in the case of a block code or to the constraint length (n.m) of the code in the case of a convolutive code, then examining the state (Syndr) of the syndrome(s) delivered by said decoder(s) (10) and if they are not all null shifting by one pulse the sector synchronisation signal (Sync), then if necessary preparing said decoder(s) (10) to receive the next L bits, and so on until said syndrome(s) are found to be all null a predetermined number ($\underline{d}$) of times in succession, the sector synchronisation (Sync) no longer being shifted during these ($\underline{d}$) repetitions if they are positive, after which the descrambler(s) (12) of the receive installation are disabled (if they were not disabled at the same time as the error corrector) and frame synchronisation is effected by using the extra-bit demultiplexer (13) of said receive installation to extract the extra-bits (HX1) of the frame alignment word (F.A.W.), comparing them to said frame alignment word, and when these are coincident initialising the frame counter (48) of the timebase (39), frame synchronisation being deemed to be acquired after confirmation on a plurality of consecutive frames.

2. Method according to claim 1 characterised in that it is applied to digital transmission with a bit error rate not significantly exceeding $1.10^{-4}$.

3. Method according to claim 2 characterised in that the number ($\underline{d}$) of consecutive confirmations that said syndromes are found to be null is between 2 and 5, i.e. $2 \leqq d \leqq 5$.

4. Method for synchronising frames received in a digital transmission installation using non-cyclic code error corrector coding/decoding, said device further comprising a frame synchronisation state controller (45) controlled by a sequencer (34) and a timebase (39), characterised in that it comprises successively and for each binary bit stream received a series error corrector coding/decoding device (10) using the WYNER-ASH code, a differential decoder (11), a descrambler (12) and an extra-bit demultiplexer (13) supplying extra-bits including the extra-bits showing the position of a frame alignment word (F.A.W.) to a shift register (54), said device further including said sector synchronisation state controller (35), a frame synchronisation state controller (45) controlled by said sequencer (34), said shift register (54) cooperating with a comparator circuit (56) to compare its content with that of a register (59) containing said frame alignment word (F.A.W.), said sector synchronisation state controller (35) supplying a sector synchronisation acquired signal when, by successive shifting of said timebase (39), the syndromes from said error corrector/coding/decoding device (10) are all null syndromes.

Rentrer L bits
dans chaque décodeur    1

Chaque syndrome
est nul ?    2

non      oui

Compteur = 0    4

Rentrer L bits
dans chaque décodeur    5

Chaque syndrome
est nul ?    6

non      oui

Incrémentation
compteur    7

3

Décaler la
synchronisation
d'un bit
Préparer les décodeurs
pour les L bits suivants

Compteur = d
?    8

oui      non

SST

# Fig.1

Fig.2

EP 0 388 842 B1

Fig.3

Fig.4

Fig. 5